# EUROPEAN PATENT APPLICATION

(11) **EP 4 760 109 A1**
(43) Date of publication of application: **17.06.2026**
(21) Application number: 25221255.0
(22) Date of filing: 05.12.2025
(51) Int. Cl.: F04D 13/12, F04B 49/06, F04C 14/02, F04D 15/00, F04D 15/02, H05K 7/20

(54) **LOAD-BALANCING FUNCTIONALITY IN A PUMP UNIT**

(30) Priority: 12.12.2024 DE 102024137496
(71) Applicant: Danfoss A/S, 6430 Nordborg (DK)
(72) Inventor: Kapici, Erhan, 6430 Nordborg (DK); Larsen, Lars Finn Sloth, 6430 Nordborg (DK)
(74) Representative: Keil & Schaafhausen Patentanwälte PartGmbB

(57) **Abstract**

The invention relates to a controller (80) for a pump (42) with a variable pump capacity (PPC) in a pump unit (41). It has a sensor interface (81) for receiving internal signals (ITS) and a communication interface (82) for receiving the external signals (EXS) from a first fluid circuit (10) with further pump units (41a, 41b). It obtains an individual pressure increase (IPI) over the pump (42) with the internal signals (ITS). In a normal-mode operation, it controls the pump capacity (PPC) based on the external signals (EXS). It determines if the external signals (EXS) are received no longer and/or receives a failure-indication signal from the first fluid circuit (10), and then automatically switches to a failure-mode operation. It stores reference information (RFI) based at least on a part of the external signals (EXS) in the normal-mode operation in a memory (83) and controls, in the failure-mode operation, the pump capacity (PCC) based at least on the individual pressure increase (IPI) and the reference information (RFI); and/or it controls, in the failure-mode operation, the pump capacity (PPC) based at least on the individual pressure increase (IPI), on the pump capacity (PCC), and a failure-mode specific adaptation of a deadband (DB) for controlling the pump capacity (PCC). The invention also relates to a cooling distribution unit (30) with the controller (80), a data center cooling system (1) with the latter, and a method for controlling a pump (42).

## Description

The invention relates to a controller for controlling a pump with a variable pump capacity in a pump unit for a first fluid circuit. The invention further relates to a cooling distribution unit, with a pump unit having a pump, for a data center cooling system, to a data center cooling system, and to a method for controlling a pump with a variable pump capacity of a pump unit.

Due to the increasing demand for computing power, new data centers are built, and existing data centers are enlarged or updated. For example, the data centers are server farms, cloud computing centers, mainframe computers, and the like.

Such a data center includes parts of an **IT** infrastructure that generate heat during operation, e.g. server racks. Such parts of the **IT** infrastructure must be cooled in order to ensure proper and safer operation.

The efficient cooling of the **IT** infrastructure is a crucial aspect. Data centers, which house large amounts of computing equipment, generate significant amounts of heat that must be effectively managed to ensure the reliability and longevity of the **IT** infrastructure.

One common method for managing heat in data centers is to provide the data center with a data center cooling system that comprises at least one of an inner, first fluid circuit and an outer, second fluid circuit. I further comprises several cooling distribution units (CDUs) for thermal coupling between this inner, first fluid circuit and the outer, second fluid circuit. The outer, second fluid circuit is sometimes referred to as facility system.

Such an inner, first fluid circuit provides cooling to relevant heat-generating parts of the **IT** infrastructure, for example via direct cooling of said parts, especially direct-to-chip liquid cooling. The first fluid circuit is sometimes referred to as technology cooling system loop (TCS loop). A first fluid is circulated in the first fluid circuit. The first fluid can be also referred to as "coolant". Typically, the first fluid circuit is a closed system.

The outer, second fluid circuit takes up heat from the first fluid circuit and further dissipates the heat. For example, the second fluid circuit can comprise air/water or water/water chillers or dry coolers to dissipate heat to the environment. A second fluid is circulated in the second fluid circuit.

The data center cooling system typically includes several cooling distribution units for the heat exchange between the at least one first fluid circuit and the second fluid circuit. Even a single first fluid circuit is typically thermally coupled to the second fluid circuit by several cooling distribution units.

Each cooling distribution unit comprises a first fluid section for fluid coupling with the inner, first fluid circuit, a second fluid section for fluid coupling with the outer, second fluid circuit, and further a heat exchanger for providing heat transfer between the first fluid section and the second fluid section. The firs fluid circuit has a pump for pumping the first fluid. The cooling distribution units, especially the heat exchangers, separate the first fluid from the second fluid.

Using several cooling distribution units, even for a single first fluid circuit, allows for easy and flexible scaling of a cooling capacity of the first fluid circuit and adds redundancy and thereby resilience to the entire system.

The cooling capacity of the first fluid circuit is adjustable via the cooling distribution units that are fluidly coupled with this first fluid circuit. It can be assumed that the cooling capacity of the first fluid circuit is determined by the cooling capacities of the corresponding cooling distribution units. In each individual cooling distribution unit, the first fluid section can include a pump with a variable pump capacity for pumping the first fluid, and a local pump driver for driving this pump. The flow rates through the first fluid sections of the individual cooling distribution units add up to a common, general flow rate of the corresponding first fluid circuit. Each cooling distribution unit can influence the cooling capacity provided by the first fluid circuit, especially by changing the pump capacity of its pump. Accordingly, the general flow rate in the first fluid circuit can be adjusted and optimal operating conditions can be ensured in the first fluid circuit by controlling the pump speeds of the pumps within the cooling distribution units.

It is desired that all pumps of the cooling distribution units forming part of the same first fluid circuit and pumping the first fluid therein are operated with a similar pump capacity (e.g. compared to their respective maximum pump capacity). This requires some coordination of the pumps in this first fluid circuit. For example, the first fluid center includes a central master controller for controlling the pumps. The central master controller checks e.g. a general flow of the first fluid in a common section of the first fluid circuit and provides command signals for adjusting the pump capacities of the pumps to the cooling distributions units, in more detail to the local pump drivers.

With such an approach, the data center cooling system does not work properly any longer if communication between the central master controller and local pump drivers fails. Further, it is desired to prevent to maintain at least some residual load-balancing between the pumps even in the case of communication failure.

One approach is to implement redundant communication systems. If the communication via a primary communication system fails, the second communication system is used to maintain communication between the master controller and the individual pump drivers. As a consequence, the proper operation of the pump and the load-balancing of the pumps is ensured even if the primary communication system fails. However, such a solution is complex and expensive. Further, the data center cooling system will not work properly if the secondary communication system fails, too, and/or if the master controller fails.

The problem underlying the invention to provide cost-efficient and yet reliable residual load-balancing between pump units forming part of the same first fluid circuit.

This problem is solved by a controller according to claim 1.

The controller is for controlling a pump with a variable pump capacity in a pump unit for a first fluid circuit.

The first fluid circuit is provided with several pump units for cycling a first fluid in the first fluid circuit and provides external signals including information on
- a global pressure drop in the first fluid circuit.
- a global average pump capacity of the pump units in the first fluid circuit, and/or
- individual pump capacities of the other pumps of the other pump units in the first circuit.

The pump unit has measurement means for providing internal signals that are indicative of an individual pressure increase of the first fluid in the pump unit caused by the pump.

The controller comprises a sensor interface for receiving the internal signals, a communication interface for receiving the external signals, and a memory.

The controller is configured to
- obtain the individual pressure increase based on the internal signals,
- control the pump capacity based on the external signals in a normal-mode operation;
- determine that the external signals are received no longer and/or receive a failure-indication signal from the first fluid circuit, and, in response, automatically switch to a failure-mode operation.

The controller is further configured to store reference information in the memory, wherein the refence information is based at least on a part of the external signals received by the controller in the normal-mode operation, and control, in the failure-mode operation, the pump capacity based at least on the individual pressure increase and the reference information.

Alternatively or additionally, the controller is configured to control, in the failure-mode operation, the pump capacity based at least on the pump capacity of the pump, e.g. based at least on a transitional average of the pump capacity, and a failure-mode specific adaption of a deadband for controlling the pump capacity.

The invention allows to provide cost-efficient and yet reliable load-balancing in the normal-mode operation. It further allows easy implementation of at least residual load-balancing the failure-mode operation between the pump units forming part of the same first fluid circuit.

In the failure-mode operation, the controller controls the pump independently. Even when a data processing means of the first circuit for providing the externals is not functional or at least cannot communicate with the controller any longer (e.g. to disconnection of a data connection), the controller continues to operate the pump independently. Even the central data processing means and/or some or all of the controllers of the other pump units fail (e.g. to failure of one or more power supply circuits), the controller and hence the pump unit with the pump controlled by this controller continue operation in failure-mode operation.

Naturally, the disclosed approach may be used for several of or all of the pump units (and their controllers). This allows for a high degree of redundancy in a cost-efficient and yet reliable manner.

According to one aspect, the controller is configured to perform, in the normal-mode-operation, load-balancing and/or synchronizing of the pump with other pumps based on the external signals.

According to one aspect, the term pump capacity may mean a pump speed and/or a pump speed with which the pump operates.

Naturally, the controller knows the pump capacity that the controller sets for its own pump, i.e. for the pump that is controlled by the controller and is in the same pump unit. Hence, if the controller knows the individual pump capacities of the other pumps of the other pump units, it can calculate the global average pump capacity of the pump units. Accordingly, the external signals are in any case indicative of the general pressure drop and/or the residual load-balancing. In the normal-mode operation, the controller uses the external signals to control its pump. In the normal-mode operation, the controller may set the pump capacity of its pump without considering the individual pressure increase in the pumping unit for setting the pump capacity.

The general pressure drop may be determined between at least two locations inside a common part of the first fluid section that is fluidly connected with all pumps. For example, the general pressure drop can be a pressure difference (a pressure drop) between a first pressure at a first location in the common part and a second pressure at a second location in the common part. The first location can be in a common fluid supply branch of the first fluid system. The second location can be in a common fluid return branch of the first fluid system.

The controller automatically switches into failure-mode operation in response to certain failure circumstances. This ensures continuous operation of the pump unit. As a result, the cooling of the data center cooling system provided to the IT infrastructure is continuously provided.

As noted above, the controller can be configured to (automatically) determine that the external signals are received no longer. In one embodiment, the controller is configured to determine that the external signals are received no longer if at least a part of the external signals has been not received for at least a predetermined period of time. Naturally, the controller may be configured to determine that the external signals are received no longer if none of the external signals has been received for at least a predetermined period of time.

For example, the controller may include a watchdog timer for reception of the external signals. Additionally or alternatively, the controller may determine that that - the applicable one(s) of - the information on the global pressure drop in the first fluid circuit, the global average pump capacity of the pump units in the first fluid circuit, and/or the individual pump capacities are no longer received and/or incomplete.

As noted above, additionally or alternatively, the controller is configured to receive the failure-indication signal from the first fluid circuit. For example, the data processing means of the first fluid circuit (which can be one of the controllers of the pump units) may determine that general pressure measurement means for measuring the general pressure drop fail and/or provide unplausible measurement results. The data processing means may be configured to communicate the failure-indication signal to the controllers in the pump units in this case. In response thereto, the controllers switch to the failure-mode operation, respectively.

In one embodiment, the controller is configured to control, in the failure-mode operation, the pump capacity based at least on a transitional average of the pump capacity and the failure-mode specific deadband for the pump capacity.

In one embodiment, the controller includes a proportional integral controller module for controlling the pump capacity. This allows easy, cost-efficient and reliable implementation. It also allows for well-predictable behavior of the controller.

The controller may include a set-point. The set-point may be adjustable, e.g. via a user interface and/or the communication interface.

According to one aspect, the controller may be configured to maintain the same set-point or to apply a predetermined set-point when switching to the failure-mode operation and/or while operating in the failure-mode operation.

The controller may be configured to control, in the failure-mode operation, the pump capacity based at least on the individual pressure increase, on the pump capacity of the pump, and a failure-mode specific adaptation of a deadband for controlling the pump capacity, wherein the failure-mode specific adaption is based on a transitional average of the pump capacity. Relying on the transitional average for the adaptation results in more stable control.

According to one aspect, the deadband may have an upper deadband limit and the controller may be configured to decrease the upper deadband limit, in the failure-mode operation, when the transitional average of the pump capacity is close to or at a maximum pump capacity (in order to decrease the pump capacity).

For example, the controller may be configured to decrease the upper deadband limit by a predetermined value when the transitional average of the pump capacity is above an upper average capacity threshold. The upper deadband limit may be reset after a predetermined time period and/or when the transitional average of the pump capacity becomes the same as or lower than the upper average capacity limit.

Additionally or alternatively, the deadband may have a lower deadband limit. The controller may be configured to increase the lower deadband limit, in the failure-mode operation, when the transitional average of the pump capacity) is close to or at a minimum pump capacity (in order to increase the pump speed). For example, the controller may be configured to increase the lower deadband limit by a predetermined value when the transitional average of the pump capacity is below a lower average pump capacity threshold. The lower deadband limit may be reset after a predetermined time period and/or when the transitional average or the pump capacity becomes the same as or larger than the lower average capacity limit.

In one embodiment, the upper average pump capacity threshold and the lower average pump capacity threshold are the same.

In a normal controlling approach, the controller changes the pump capacity only when the relevant pressure difference (e.g. the internal pressure increase) is outside the deadband. The controller decreases the pump capacity only when the relevant pressure difference is above the upper deadband limit. The controller increases the pump capacity only when the relevant pressure difference is below the lower deadband limit. As long as the relevant pressure difference is within the deadband, the controller does not change the pump capacity. In the failure-mode operation, the ongoing load-balancing of the pumps based on the external signals is no longer possible. If only such a normal controlling approach is applied in the failure-mode operation, it is possible that the pump works close to the upper deadband limit ongoingly or at least for a long time. Similarly, another pump might work close to the lower deadband limit ongoingly or at least for a long time. Hence, the loads of these two pumps are imbalanced. With the proposed adaption of the deadband based on the transitional average of the pump capacity, the pump capacities and hence the loads on the two pumps converge over time.

The external signals may include at least information on the global pressure drop in the first fluid circuit.

In one embodiment, the controller is configured to, in the normal-mode operation, store the reference information in the memory, wherein the refence information is based at least on the global pressure drop.

Typically, the global pressure drop (in the common section of the first fluid circuit) is lower than the local internal pressure increase. The global pressure drop is the value that should be brought to a desired value (e.g. set point) in the normal-mode operation. In the normal-mode operation, the controller may control its pump with considering (e.g. based on) the general pressure drop but without considering the internal pressure increase. However, when in the failure-mode operation, information on the global pressure drop may be no longer received. In the failure-mode operation, the controller operates the corresponding pump based at least on the internal pressure increase. With this approach, the controller can store, for example,
- the latest global pressure drop,
- the latest "good value" of the global pressure drop,
- several global pressure drops over a latest time period,
- a (e.g. transitional) average of the general pressure drop,
- a (pressure) difference between the latest global pressure drop and the internal pressure increase,
- the difference between the latest "good value" of the global pressure drop and the internal pressure increase,
- several differences between the latest global pressure drops and the internal pressure increases over a latest time period,
- a (e.g.) transitional average of the pressure difference between the latest global pressure drop and the internal pressure increase
in the memory as (forming part of) the reference information.

In the failure-mode operation, the controller can control the pump based at least on the internal pressure increase with considering that the actual global pressure drop is lower than the internal pressure increase. For this, the controller may use the reference information.

In one embodiment, the controller is configured to, in the normal-mode operation, determine (based on the internal signals and the external signals) a transitional average difference, which is a transitional average of a difference between the individual pressure increase and the global pressure drop, and to store the transitional average difference in the memory such that reference information includes the transitional average difference. Hence, the transitional average difference is regularly updated in the normal-operation mode and readily available when the controller must switch to the failure-mode. It is hence the transitional average difference right before the controller switches from the normal-mode operation to the failure-mode operation.

Especially, the controller can be configured to determine, in the normal-mode operation, the transitional average difference for at least a certain time period, a minimum number of values of the global pressure drop, and/or a minimum number of values of the individual pressure increase.

For example, the certain time period can be at least 5 minutes, maybe at least 10 minutes, for example at least 25 minutes. Additionally or alternatively, the certain time period can be at the maximum 5 hours, maybe at the maximum 1,5 hours, for example at the maximum 45 min.

Typically, the difference between the individual pressure increase and the global pressure drop is relatively stable. The failure-mode operation will typically not last very long. It can be assumed that the pressure difference during the failure-mode operation will remain the same or at least substantially the same as the latest transitional average difference in normal-operation mode before switching to the failure mode.

Naturally, it is also possible the controller stores, in the normal-mode operation, for at least the certain time period, the minimum number of values of the global pressure drop, and/or the minimum number of values of the individual pressure increase (values of)
- the global pressure difference and the internal pressure increase and/or
- the difference between the individual pressure increase and the global pressure drop,
and to calculate the transitional average difference (retrospectively) when switching from the normal-operation mode to the failure-operation mode.

According to one aspect, the controller might be configured to, in the failure-mode operation,
- offset the individual pressure increase based on the reference information and
- use the offset individual pressure increase for controlling the pump.

For example, the controller may offset the individual pressure increase by adding the transitional average difference. This is an easy and reliable way to ensure that a more appropriate general pressure drop in the first fluid circuit in the failure-mode operation although the controller uses the individual pressure increase instead of the (no more available values of) the general pressure drop for controlling the pump.

In one embodiment, the controller is configured to, in the normal-mode operation,
- receive the global average pump capacity, e.g. from a data processing means and/or receive the individual pump capacities of the other pumps and to determine the global average pump capacity based on the received pump capacities of the other pumps and the pump capacity for the pump, and
- control the pump based on the global average pump capacity.

The controller automatically the pump capacity for its pump to the pump capacities of the other pumps. This ensures proper load-balancing in the normal-operation mode in an easy and efficient manner. The first fluid circuit with the several pump units is nevertheless adaptive to influences that require a rising or falling total capacity.

This disclosure is also directed to a pump unit with the controller according to the invention. It is further directed to a first fluid circuit (e.g. as described) including at least two of such pump units, maybe at least three of such pump units. The embodiments, modifications, and advantages described with respect to the controller apply accordingly for the pump unit and the first fluid circuit and their uses, and vice versa.

The problem mentioned above is further solved by a cooling distribution unit with a controller according to the invention.

In particular, the problem mentioned above is solved by a cooling distribution unit with the features of claim 11.

It is a cooling distribution unit, with a pump unit having a pump, for a data center cooling system.

The data center cooling system comprises a first fluid circuit for providing cooling to parts of an **IT** infrastructure in a data center, and a second fluid circuit for dissipating heat, wherein the first fluid circuit is provided with several pump units for cycling a first fluid in the first fluid circuit and provides external signals including information on
- a global pressure drop in the first fluid circuit,
- a global average pump capacity of the pump units in the first fluid circuit, and/or
- individual pump capacities of other pumps of the other pump units in the first circuit,

The cooling distribution unit comprises:
a first fluid section for fluid coupling with the first fluid circuit, wherein the pump unit forms part of the first fluid section and includes measurement means for measuring an individual pressure increase of the first fluid in pump unit caused by the pump;
a second fluid section for fluid coupling with the second fluid circuit;
a heat exchanger for heat coupling between the first fluid section and the second fluid section; and
a controller for controlling the pump according to the invention.

The embodiments, modifications, and advantages described regarding the controller, the pump unit, and/or the first fluid circuit may apply accordingly regarding the cooling distribution unit and its use, and vice versa.

The problem mentioned above is further solved with a data center cooling according to claim 12.

The data center cooling system includes a first fluid circuit for providing cooling to parts of an IT infrastructure in the data center, wherein the first fluid circuit is configured to provide external signals that are indicative of a global pressure drop concerning the first fluid circuit, and a second fluid circuit for dissipating heat;

wherein the data center cooling system includes at least two cooling distribution units according to the present invention, wherein the first fluid sections of the at least two cooling distribution units form part of the first fluid circuit, and wherein the first fluid circuit includes a data processing means for providing the external signals.

According to one aspect, one of the controllers is the data processing means or wherein the first fluid circuit includes a master controller as the data processing means.

The data center cooling system may include general pressure measurement means for providing general measurement signals that are indicative of the general measurement drop. Said general pressure measurement means include at least pressure differential sensor. Additionally or alternatively, said general pressure measurement means may include a first general pressure sensor for measuring a first sensor and a second sensor for measuring a second general pressure.

The embodiments, modifications, and advantages described regarding the controller, the pump unit, the first fluid circuit, and/or the cooling distribution unit may apply accordingly regarding the data center cooling system and its use, and vice versa.

The data processing unit may be coupled to the general pressure measurement means for receiving the general measurement signals.

Further, the problem indicated above is solved by a method according to claim 14.

The method is for controlling a pump with a variable pump capacity of a pump unit (for example in a cooling distribution unit according to the present invention) in a first fluid circuit (for example in a data center cooling system according to the present invention),
wherein the first fluid circuit is provided with several pump units that are cycling a first fluid in the first fluid circuit and wherein a data processing means provides external signals including information on
   - a global pressure drop in the first fluid circuit,
   - a global average pump capacity of the pump units in the first fluid circuit, and/or
   - individual pump capacities of the other pumps of the other pump in the first circuit,
wherein measurement means of the pump unit provide internal signals that are indicative of an individual pressure increase of the first fluid in the pump unit caused by the pump;

The method comprises:
- obtaining, with the controller, the individual pressure increase based on the internal signals ,
- receiving, in a normal-mode operation, the external signals by the controller,
- controlling, in the normal-mode operation, the pump capacity with the controller based on the external signals;
- determining, with the controller, that controller receives the external signals are received no longer and/or receiving, with the controller, a failure-indication signal from the first fluid circuit, and, in response, automatic switching of the controller to a failure-mode operation;

The method further comprises
- obtaining, with the controller, the individual pressure increase based on the internal signals, storing reference information in the memory, wherein the refence information is based at least on a part of the external signals received by the controller in the normal-mode operation, and controlling, in the failure-mode operation, the pump capacity with the controller based at least on the individual pressure increase and the reference information and/or
- controlling, in the failure-mode operation, the pump capacity with the controller based at least on the pump capacity of the pump and a failure-mode specific deadband for the pump capacity.

The embodiments, modifications, and advantages described regarding the controller, the pump unit, the first fluid circuit, the cooling distribution unit, and/or the data center cooling system may apply accordingly regarding the method, and vice versa.

Additional features, advantages and possible applications of the invention result from the following description of exemplary embodiments and the drawings. All the features described and/or illustrated graphically here form the subject matter of the invention, either alone or in any desired combination, regardless of how they are combined in the claims or in their references back to preceding claims.

Preferred embodiments of the invention will now be described with reference to the drawings, in which:
- Fig. 1: schematically shows a data center cooling system with an inner, first fluid circuit for providing cooling to parts of an IT infrastructure in a data center, an outer, second fluid circuit for dissipating heat, and two cooling distribution units for transferring heat from the first fluid circuit to the second fluid circuit, wherein each of the cooling distribution units comprises a pump unit with a pump for pumping a first fluid in the first fluid circuit and a controller for controlling the pump;
- Fig. 2: schematically shows an embodiment of an embodiment of a controller that can be used in the cooling distribution units of Fig. 1 and its interactions;
- Fig. 3: schematically shows a load-balancing of pump capacities of the pumps in Fig. 2 in normal mode based on a global average pump capacity;
- Fig. 4: schematically shows a difference between an internal pressure increase in a pump unit caused by the pump and global pressure difference, wherein the controller of Fig. 2 no longer receives external signals indicating the global pressure difference starting at a time of communication failure;
- Fig. 5: schematically shows how the controller of Fig. 2 uses a transitional average difference, which the controller determines and stores in a normal-mode operation before the time of communication failure, to offset the internal pressure increase in a failure-mode operation after the time of communication failure;
- Fig. 6: schematically shows a failure-mode specific adaption of a deadband for controlling the pump capacity in the controller of Fig. 2;
- Fig. 7: schematically shows a development of the pump capacities of two pumps over time.

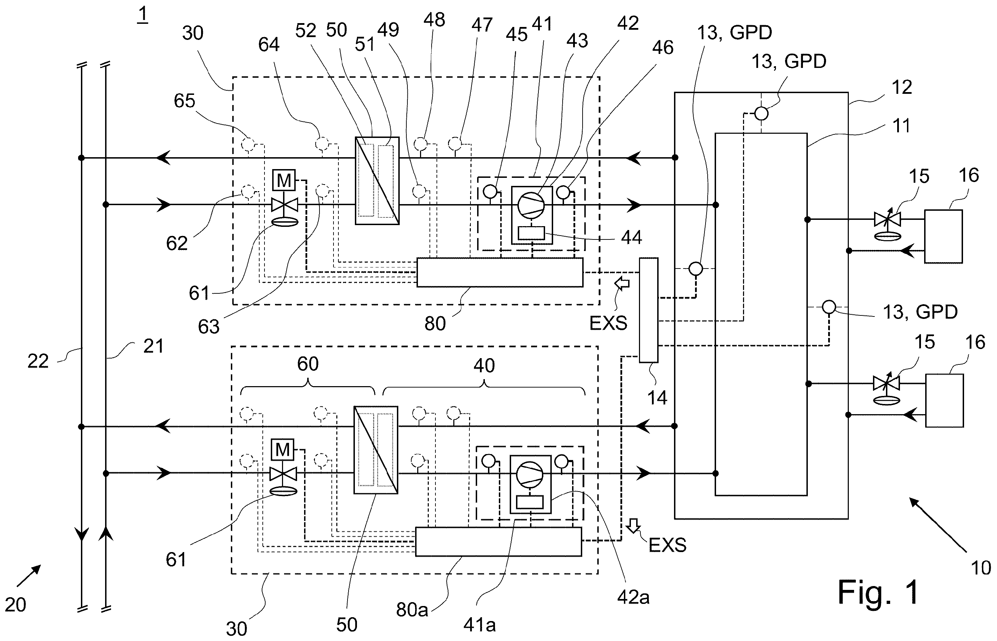

Fig. 1 shows a data center cooling system 1 with an inner, first fluid circuit 10 and an outer, second fluid circuit 20.

The first fluid circuit 10 provides cooling to parts 16 of an IT infrastructure in a data center. The parts 16 can, for example, include or consist of server racks. The first fluid circuit 10 may be used for direct-to-chip liquid cooling in the parts 16. A first fluid is circulated in the first fluid circuit 10. The first fluid can include water and/or glycol. For example, the first fluid can be a water-glycol-mixture.

The data center cooling system 1 includes at least one cooling distribution unit 30. Despite of Fig. 1 showing two cooling distribution units 30, the data center cooling system 1 can also include only one cooling distribution unit 30 or more than two cooling distribution units 30.

The cooling distribution units 30 couple the first fluid circuit 10 to the second fluid circuit 20. In particular, in operation, the cooling distribution units 30 transfer heat from the first fluid circuit 10 to the second fluid circuit 20. The second fluid circuit 20 dissipates the heat further, e.g. via outdoor heat exchangers (not shown) of the data center cooling system 1. A second fluid is circulated in the second fluid circuit 20. The second fluid can include water and/or glycol. For example, the second fluid can be a water-glycol-mixture. The second fluid and the first fluid can be of the same fluid composition or of different fluid compositions.

Further, the cooling distribution units 30 pump the first fluid, thereby circulation the first fluid in the first fluid circuit 10.

In modifications (not shown), the data center cooling system 1 can include several (at least two) first fluid circuits 10, each of the first fluid circuits 10 being thermally coupled to the second fluid circuit 20 by corresponding cooling distribution units 30, respectively.

Turning back to Fig. 1, the first fluid circuit 10 includes a fluid supply branch 11 for supplying the first fluid from the cooling distribution units 30 to the parts 16 and a fluid return branch 12 for returning the first fluid from the parts 16 to the cooling distribution units 30. The first fluid circuit 10 can include valves 15 for controlling fluid supply to the individual parts 16.

The second fluid circuit 20 includes a fluid supply branch 21 for supplying the second fluid to the cooling distribution units 30 and a fluid return branch 22 for discharging the second fluid from the cooling distribution units 30.

In the following, the individual cooling distribution unit 30 is described in more detail.

The cooling distribution unit 30 comprises a first fluid section 30 that is fluidly coupled with the first fluid circuit 10, in more detail with the fluid supply branch 11 and the fluid return branch 12. Further, the cooling distribution unit 30 comprises a second fluid section 60 that is fluidly coupled with the second fluid circuit 20, in more detail with the fluid supply branch 21 and the fluid discharge branch 22.

A heat exchanger 50 of the cooling distribution unit 30 provides thermal coupling between the first fluid section 40 and the second fluid section 60 and hence between the inner fluid circuit 10 and the second fluid circuit 20. The heat exchanger 50 includes a first flow branch 51 (also referred to as inner flow branch 51) that forms part of the first fluid section 30 and is hence fluidly coupled with the first fluid circuit 10. A second flow branch 52 of the heat exchanger 50 (also referred to as outward flow branch 21) forms part of the second fluid section 60 and is hence fluidly coupled with the second fluid circuit 20. Accordingly, it may be considered that the heat exchanger 50 forms part of both the first fluid section 40 and the second fluid section 60.

The heat exchanger 50 prevents mixing of the first fluid and the second fluid. The cooling distribution unit 30 (especially the heat exchanger 50) provides thermal coupling between the second fluid circuit 20 and the first fluid circuit 10 without fluid coupling between the second fluid circuit 20 and the first fluid circuit 10.

The second fluid section 60 may include at least one valve 61 and one or several sensors, e.g. temperature sensors 62, 65 and/or pressure sensors 63, 64.

Further, each cooling distribution unit 30, more specifically its first fluid section 40, has a pump unit 41

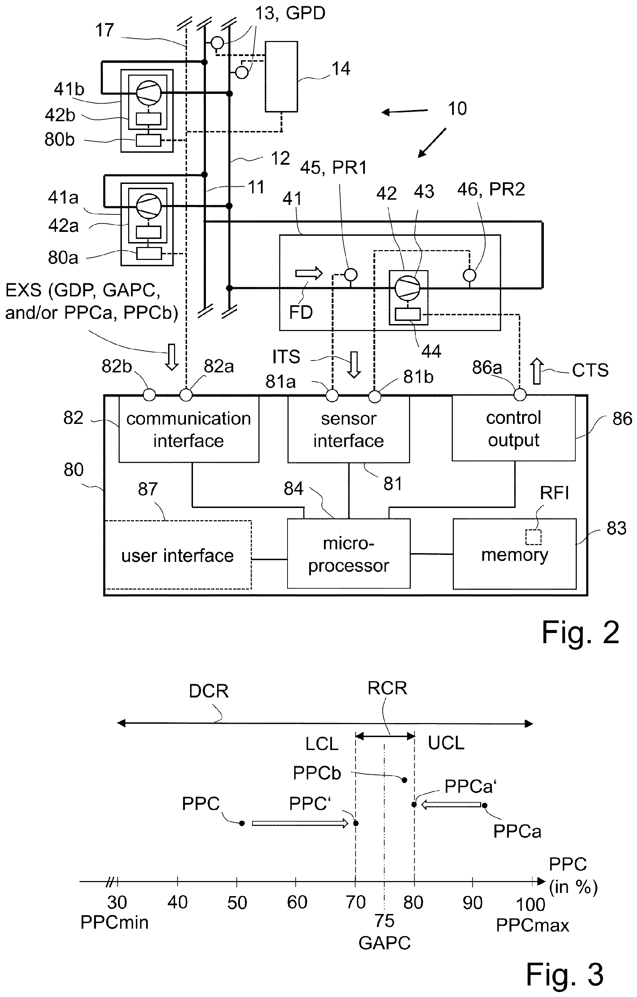

The pump unit 41 includes a pump 42 for pumping the (first) fluid flowing through the first fluid section 30 (and hence through the first fluid circuit 10). The pump unit 41 is also shown in Fig. 2.

The pump 42 can comprise a pump element 43 with a pump motor and pump driver 44. The pump driver 44 can be configured to drive the pump motor in accordance with control signals CTS (see Fig. 2) provided by a pump controller 80.

Naturally, the controller 80 can form part of the pump unit 41.

The pump 42 has a variable pump capacity PCC (see, for example, Fig. 3). The pump capacity PCC may be adjustable (in particular under control of the controller 80) within a default pump capacity range DCR from a minimum pump capacity PCCmin to a maximum pump capacity PCCmax. The minimum pump capacity PCCmin might be in the range from 20 % to 50 % of the maximum pump capacity PCCmax, e.g. 30 % thereof.

In Figs. 1 and 2, each pump 42 contributes to circulating the first fluid in the first fluid circuit 10.

The pump unit 41 further includes measurement means for providing internal signals ITS that are indicative of an internal pressure increase IPI of the first fluid within the pump unit 41. The individual pressure increase is caused by the pump 42.

The internal pressure increase IPI is the difference between a first pressure PR1 at a first location in a flow path through the pump unit 41 and a second pressure PR2 at a second location in the flow path (IPI = PR2 - PR1). The pump 42 is arranged in the flow path between the first location and the second location. For example, in Fig. 2, the first location is upstream of the pump 42 and the second location is downstream of the pump 42 along an intended flow direction FD of the first fluid through the pump unit 41 in operation.

The measurement means (the entirety thereof) generate internal pressure signals ITS that are indicative of the internal pressure increase IPI. In the exemplary embodiment, the measurement means include a first pressure measurement means 45 (e.g. including a pressure sensor, a pressure transmitter, and/or a pressure transducer) measuring the first pressure PR1 at the first location and a second pressure measurement means 46 (e.g. including a pressure sensor, a pressure transmitter, and/or a pressure transducer) measuring the second pressure PR2 at the second location. Hence, the internal pressure signals ITS provided by the combination of the first pressure measurements means 45 and the second pressure measurement means 46 are indicative of the internal pressure increase IPI = PR2 - PR1. Additionally or alternatively, the measurement means of the pump unit 41 could include a differential pressure sensor (not shown).

In addition, the first fluid section 40 can include at least one temperature sensor for measuring a temperature of the first fluid. Fig. 1 shows a first temperature sensor 47 that measures a first temperature at a first temperature location and a second temperature sensor 49 that measures a second temperature on a second temperature location along a fluid path for the first fluid in the first fluid section 40. The first temperature location is located upstream of the (first flow branch 51) of the heat exchanger 50 and the second temperature location is located downstream of the (first flow branch 51) of the heat exchanger 50. The controller 80 can be configured to obtain a temperature drop of the first fluid over the (first flow branch 51) of the heat exchanger 50.

In Fig. 1, the pump unit 41 is arranged in the first fluid section 31 downstream of the heat exchanger 50. The first fluid section can additionally include a pressure measurement means 47, e.g. to measure a pressure of the first fluid upstream of the heat exchanger 50. The arrangement could be vice versa instead.

Turning back to Fig. 2, the controller 80 is explained in more detail.

The controller 80 comprises a sensor interface 81 for receiving the internal signals ITS from the pump unit 41, in particular from the pressure measurement means. In this example, the sensor interface 81 has a first input 81a for the first pressure measurement means 45 and a second input 81b for the second pressure measurement means 46. Further inputs for the other sensors in the same cooling distribution unit 1 shown in Fig. 1 are optional.

The controller 80 further has a communication interface 82 for receiving external signals EXT from another data processing means of the first fluid circuit 10, e.g. from a central master controller 14 and/or from the controllers 80a, 80b of other pump units 41a, 41b in the first fluid 10. In general, the communication interface 82 may be configured for data exchange with electronic devices. It may be configured for wired and/or wireless communications. For example, it might include a bus interface (such as a fieldbus interface and/or a CAN bus interface), a local area network interface, a Bluetooth^{®} interface, and/or the like. The communication interface 82 may include at least one connector terminal 82a, 82b, e.g. at least one RJ-45 connector and/or another connector terminal.

In addition, the controller 80 has a memory 83. For example, the controller 80 uses the memory 83 for storing reference information RFI that is based on the external signals EXS that are received in a normal-mode operation.

The controller 80 further has a (micro-)processor 84 to which the sensor interface 81, the communication interface 82, and the memory 83 are connected.

The controller 80 can include a control output 86 for sending the control signals CTS to the pump 42, e.g. via an output connector 86a. In general, the controller 80 be also integrated in the pump 42 as well. The control output 86 is connected to the microprocessor 84 or forms part of the microprocessor 84.

Optionally, the controller 80 includes a user interface 87. The user interface 87 may comprise a screen, e.g. a touchscreen, buttons, and/or sound-generating means. The user interface 87 may be detachable. In the latter case, it can be sufficient that the evaluation module 80 comprises a mount for detachably mounting the user interface 87. The user interface 87 can be adapted for receiving user input and/or to present information to the user, e.g. including graphic output (for example via the screen/touchscreen) and/or audio output. For example, the user interface may be configured to indicate to the user, e.g. via the screen and/or the sound-generating means that the controller 80 has switched to the failure-mode operation.

The first fluid circuit 10 includes several pump units 41, 41a, 41b (see Fig. 2).

The pump units 41, 41a, 41b, and especially the pumps 42, 42a, 42b of the pump units 41, 41a, 41b, are fluidly connected via the first fluid circuit 10. The pump units 41, 41a, 41b may be arranged in parallel and/or in series in the first fluid circuit 10.

Each pump unit 41, 41a, 41b has an individual pump 42, 42a, 42b, and an individual controller 80, 80a, 80b for controlling the corresponding pump 42, 42a, 42b in the same pump unit 41. The controllers 80a, 80b can be of the same type of the controller 80. The first fluid circuit 10 further includes general pressure measurement means 13 for measuring a general pressure drop GPD in a common section of the first fluid circuit 10, e.g. for measuring the general pressure drop GPD from the common supply branch 11 to the common return branch 12.

The data processing means in the first fluid circuit 10 is functionally coupled to the general pressure measurement means 13. The data processing means can include or consist of the separate central master controller 14. In this case, the master controller 14 may communicate the external signals EXS including information on the general pressure drop GDP to the controller 80 of all pumps 42, 42a, 42b. In a modification (not shown), one of the controllers 80, 80a, 80b is employed as the data processing means and functionally coupled with the general pressure measurement means 13. In this case, this one of the controllers 80, 80a, 80b may communicate the external signals EXS including information the general pressure drop to the other controllers 80, 80a, 80b.

In normal mode-operation, all controllers 80, 80a, 80b receive the external signals EXS and can control the corresponding pump 42, 42a, 42b based at least one the general pressure drop GDP. They are aiming to bring the global pressure drop GDP to a set point SP. This is one measure to synchronize the operation of the pump better and to bring the global pressure drop GDP more precisely to the desired value.

A further aspect for load-balancing of the pumps 42, 42a, 42b in the normal-operation mode is explained referring to Fig. 3. A global average pump capacity GAPC is calculated. The global average pump capacity GAPC is the average of the pump capacities PCC, PCCa, PCCb of all pumps 42, 42a, 42b (as set by the corresponding controllers 80, 80a, 80b). Especially, it is a transient average over an averaging time period. This averaging time period might be in the range from the last 5 minutes to the last hour, for example it might be the last 30 minutes. The controllers 80, 80a, 80b share the precent pump capacities PCC, PCCa, PCCb over a communication system 17 of the first fluid circuit 10, e.g. a bus communication system. The master controller 14 calculates the global average pump capacity GAPC and sends the corresponding external signals including this value to the controllers 80, 80a, 80b. If one of the pumps 80, 80a, 80b is used as the data processing means, it naturally needs to receive only the pump capacities PCC, PCCa, PCCb of the other controllers 80, 80a, 80b and provide the external signals including information on the global average pump capacity GAPC to the other controllers. It is also possible that the external signals EXT only include the pump capacities PCC, PCCa, PCCb and that each controller 80 calculates the global average pump capacity GAPC locally.

In the normal-operation mode (when this value is available), the individual controller 80, 80a, 80b controls its corresponding pump 42, 42a, 42b based on the global average pump capacity GAPC. The controller 80, 80a, 80b applies a restricted capacity range RCR for controlling its pump 42, 42a, 42b. The restricted capacity range RCR is smaller than the default capacity range DCR. For example, the restricted capacity range RCR is a window about the global average pump capacity GAPC, for example from (GAPC - RW/2) to (GAPC + RW/2), where RW is a range window. Naturally, the controller 80, 80a, 80b may ensure that the restricted capacity range RCR is completely within the default capacity range DCR for its pump 42, 42a, 42b.

In Fig. 3, the global average pump capacity GAPC is 75 % and the range window RW is 5 %. Without the restricted capacity range RCR, the controller 80 would adjust the (present) pump capacity PCC of its pump 42 to a value below a lower capacity limit LCL (which might be GAPC - RW/2). Hence, it instead applies the pump capacity PCC' at the lower capacity limit LCL. The controller 80a would adjust the pump capacity PCCa of its pump 42a to a value above an upper capacity limit (which might be GAPC + RW/2). Hence, it instead applies the pump capacity PCCa' at the lower capacity limit LCL (which might be GAPC - RW/2). The controller 80b determines the pump capacity PPCb for its pump 42b. As the pump capacity PPCb is within the restricted capacity range RCR (between the lower capacity limit LCL and the upper capacity limit UCL), no correction is done.

This approach ensures good load-balancing of the pumps 42, 42a, 42b. However, it does not work if the controller 80 does not receive the external signals EXS any longer, e.g. due to failure of the communication system 17.

In the following, measures are disclosed that help to maintain residual load-sharing even in the case of communication failure.

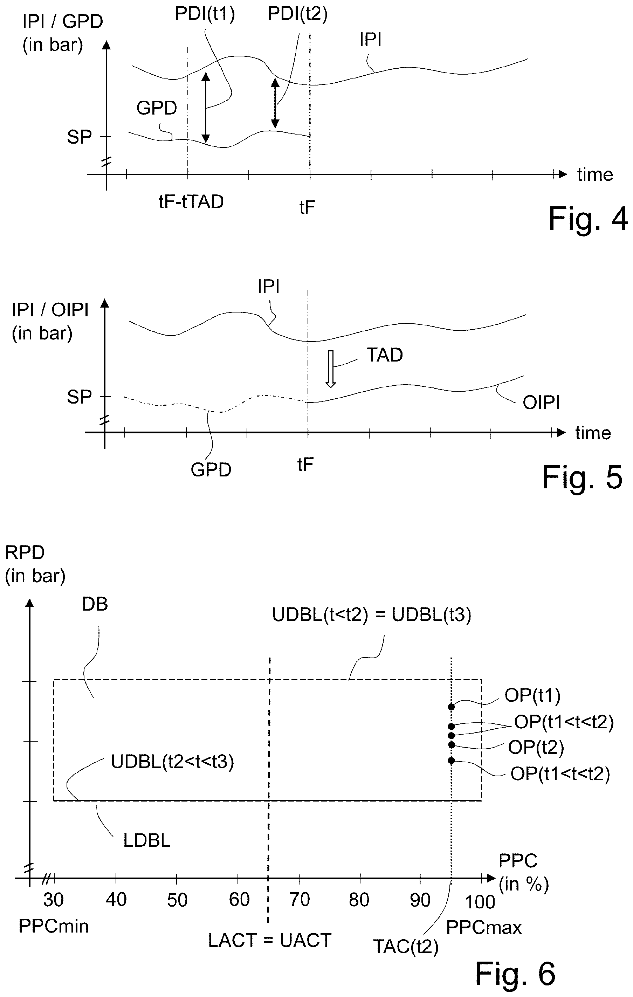

Fig. 4 shows a development of the internal pressure increase IPI as obtained by the individual controller 80 and the global pressure drop received by the controller 80 via the communication interface with the external signals EXS. Up to a time of communication failure tF, the controller 80 receives the external signals EXS and works in normal-mode operation. At the time of communication failure tF, the reception of the external signals EXS stops. The controller 80 recognizes this and automatically switches to the failure-mode operation.

During the normal-mode operation, the controller 80 does not use the internal pressure increase IPI for controlling the pump capacity PCC of its pump 42. Instead, it uses the global pressure drop GDP for controlling the pump capacity PCC. However, the controller 80 ongoingly calculates a difference PDI(t1), PDI(t2) between the internal pressure increase IPI and the global pressure drop GDP. It further determines a transitional average difference TAD (see Fig. 4) which is a transitional average of a difference PDI between the individual pressure increase IPI and the global pressure drop GPD over a certain latest time period tTAD. It then stores the transitional average difference TAD as reference information RFI (see Fig. 2) in its memory 83.

Then, in the failure-mode operation, the controller 80 retrieves the transitional average difference TAD from the reference information RFI in the memory 83. As shown in Fig, 5, it offsets the locally measured internal pressure increase IPI by the transitional average difference TAD. Then, it applies its control logic (e.g. including a proportional-integral controller module) on the offset internal pressure increase IPI. Therefore, it can consider the latest average difference between the general pressure drop GDP for obtaining better control of the pump capacity PCC in the failure-mode operation.

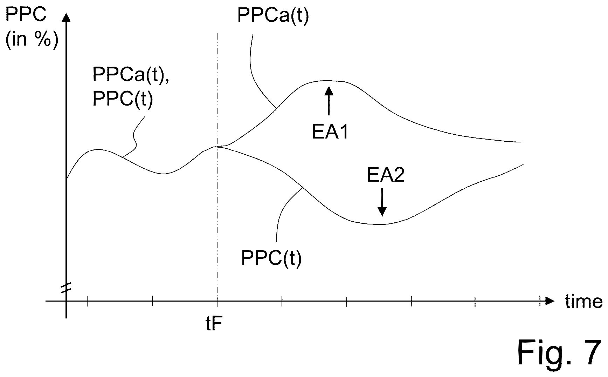

Another aspect of for better control of the pump capacities PCC, PCCa, PCCb in the failure-mode operation is explained referring to Fig. 6 and 7.

In the case of communication failure, the general average pump capacity GACP cannot be received or calculated any longer by the individual controller 80. The controller 80 has to determine the pump capacity 80 solely on information that is locally available.

In a default control approach, the controller 80 applies a deadband 80 for controlling the pump capacity PCC (see Fig. 6). The deadband 80 extends between a lower deadband limit LDBL, e.g. 1,9 bar, and an upper deadband limit UDBL, e.g. 2,1 bar. If the relevant pressure difference RPD (e.g. the general pressure drop GDP in the normal-mode operation or any one of the internal pressure increase IPI or the offset internal pressure increase IPI) is within the deadband DB, e.g. between the lower deadband limit LDBL and the upper deadband limit UDBL, the controller maintains the present pump capacity PCC.

The controller 80 increases the pump capacity PCC only when the relevant pressure difference RPD is less than LDBL and decreases the pump capacity PCC only when the relevant pressure difference RPD is higher than UDBL, regardless of the present capacity PCC. In the normal-operation mode, the controller 80 can nevertheless adapt/synchronized its pump capacity based on the external signals EXS, e.g. based on the global average pump capacity GACP as explained above. This is not possible in the case of communication failure.

Fig. 6 shows, in the failure-mode operation, an operation point OP(t1) at a time t1, several operational points OP(t1<t<t2) at times t between t1 and a time t2, and the operation point OP(t2) at the time t2. Each operation point OP can be assumed as the relevant pressure drop RPD at the respective time t. It shows that the operational points fluctuate within the deadband DB but at a very high pump capacity PCC. This is very susceptible for the pump 42 having a higher load / pump capacity PCC than the other pumps 42a, 42b. However, since all operational points OP are within the deadband DB, the controller 80 would normally not reduce the pump capacity PCC.

According to the proposed approach, the controller 80 calculates, in the failure-mode operation, an (individual) transitional average TAC of the pump capacity PPC for its pump 42. This (individual) transitional average TAC of pump capacity PPC of the individual pump 42 must not be confused with the global average pump capacity GAPC in normal-operation mode. A (pre-determined) time period for said transitional averaging may depend on the system, but it can maybe in the range from 5 minutes to 2 hours, maybe within the range from 15 minutes to 45 minutes, e.g. 30 minutes.

For example, referring to Fig. 6, this averaging time period may be from the time period from t1 to t2.

The controller 80 may at least detect when the transitional average TAC is close to or at the maximum pump capacity PPCmax. This indicates that the pump 42 operates for a longer time with particularly high pump capacity PCC. Especially, the controller 80 may detect when the transitional average TAC of the pump capacity PCC is above an upper average capacity threshold UACT. This is the case in Fig. 6.

As a result, the controller 80 reduces the upper deadband limit UDBL.

In the example of Fig. 6, the upper deadband limit UDBL(t<t2) has been the "default" upper deadband limit. At the time t2, when the controller 80 determines that the transitional average TAC of the pump capacity PCC is above the upper average capacity threshold UACT, it reduces the upper deadband limit to UDBL(t2<t<t3), which may be the same value as the default lower deadband limit LDBL. In other words, the deadband DB is restricted, in this case even "closed". As a consequence, the controller 80 starts to decrease the pump capacity PCC at the time t2. The upper deadband limit UDBL might be reset to its default value after a predetermined time period, in this example at the time t3. Additionally or alternatively, it might be reset when the transitional average TAC of the pump capacity PCC becomes the same as or lower than the upper average capacity limit. During the time period t1 to t3, the lower deadband limit LDBL is not adapted. It remains at its default value.

The target for the relevant pressure difference RPD might be not changed in the course of this process. The control objective to have the relevant pressure difference at the target at least close to it can be maintained.

In a similar manner, the controller 80 can be configured to increase the lower deadband limit LDBL, e.g. by a predetermined value, when the transitional average TAC of the pump capacity PPC is close to or at the minimum pump capacity PCCmin. For example, the controller 80 may set the lower deadband limit LDBL to the (default value) of the upper deadband limit UDBL when the transitional average TAC of the pump capacity PCC is below a lower average capacity threshold LACT. Accordingly, the controller 80 increases the pump capacity PCC. The upper deadband limit UDBL might be reset to its default value after a predetermined time period and/or when the transitional average TAC of the pump capacity PCC becomes the same as or higher than the lower average capacity limit. The UDBL deadband limit UDBL might be not adapted during this process but remain at its default value.

In the example according to Fig. 6, the lower average capacity threshold LACT and the higher average capacity threshold UACT are the same, e.g. 65 %. In other examples, each of the lower average capacity threshold LACT and the higher average capacity threshold UACT can be in the range from 50 % to 70 %, for example.

With the disclosed approach, the controllers 80, 80a, 80b adapt their deadbands DB in the failure-mode operation, for example their upper deadband limits UDBL and/or their lower deadband limits LDBL, according to the situation. This ensures at least a certain load-balancing of the pump capacities PCC despite of the individual independent local control of the pumps 42, 42a, 42b only be the corresponding controllers 80, 80a, 80b without communication.

Fig. 7 shows this very schematically for the pump capacities PPC(t) and PPCa(t) of two pumps 42, 42a. In the normal-operation mode before the time tF of communication failure, the pump capacities PPC(t) and PPCa(t) are quite synchronized. After the time tF, first the transitional average TAC (not shown in Fig. 7) of PCC(t) is above the upper average capacity threshold UACP. Correspondingly, in the event area EA1, the corresponding controller 80 lowers the upper deadband limit UDBL and decreases the pump capacity PCC(t). Later, the transitional average TAC (not shown in Fig. 7) of PCCa(t) is below the lower average capacity threshold LDBL. Correspondingly, in the event area EA2, the corresponding controller 80a increases the upper deadband limit LDBL and increases the pump capacity PCCa(t). This helps to distribute the load more uniformly between the pumps 42, 42a.

The aspects of the invention improve the reliability and the operation safety.

A "robustness" is implemented in the individual controllers 80 and hence in the individual cooling distribution units 30. Failure-mode operation is possible, even with load-balancing, without needing redundant communication infrastructure. This is very cost-efficient.

According to one aspect, all control logic for controlling the individual pumps 42, 42a, 42b is completely provided in the corresponding individual controllers 80, 80a, 80b, even for the normal-mode operation. The set point SP may be prestored in the individual controllers 80, especially in the memory 83. The controller 80 only needs the relevant information in the external signals EXS and uses this relevant information for its own control logic to finally find and set the pump capacity based on its own control logic. This allows for excellent scalability of the system, e.g. for changing the number of the cooling distribution units 30 in Fig. 1. It also allows for easy implementation of the individual failure-mode operation of each controller 80.

The disclosed approaches are especially useful in the data center cooling system 1 with several cooling distribution units 30 for the same first fluid circuit 10. Proper cooling of the IT infrastructure is ensured both in the normal-mode operation and the failure-mode operation.

However, the disclosed approaches are not limited to cooling distribution units 30. They might also be applied in a system with flow control with several booster pumps, maybe in district heating systems.

## Claims

1. A controller (80) for controlling a pump (42) with a variable pump capacity (PCC) in a pump unit (41) for a first fluid circuit (10),
wherein the first fluid circuit (10) is provided with several pump units (41, 41a, 41b) for cycling a first fluid in the first fluid circuit (10) and provides external signals (EXS) including information on
- a global pressure drop (GDP) in the first fluid circuit (10),
- a global average pump capacity (GAPC) of the pump units (41, 41a, 41b) in the first fluid circuit (10), and/or
- individual pump capacities of the other pumps (42a, 42b) of the other pump units (41a, 41b) in the first circuit (10),
wherein the pump unit (41) has measurement means (45, 46) for providing internal signals (ITS) that are indicative of an individual pressure increase (IPI) of the first fluid in the pump unit (41) caused by the pump (42);
wherein the controller (10) comprises a sensor interface (81) for receiving the internal signals (ITS), a communication interface (82) for receiving the external signals (EXS), and a memory (83).
wherein the controller (80) is configured to
- obtain the individual pressure increase (IPI) based on the internal signals (ITS),
- control the pump capacity (PPC) based on the external signals (EXS) in a normal-mode operation;
- determine that the external signals (EXS) are received no longer and/or receive a failure-indication signal from the first fluid circuit (10), and, in response, automatically switch to a failure-mode operation;
wherein the controller (80) is further configured to
- store reference information (RFI) in the memory (83), wherein the refence information (RFI) is based at least on a part of the external signals (EXS) received by the controller (80) in the normal-mode operation, and control, in the failure-mode operation, the pump capacity (PCC) based at least on the individual pressure increase (IPI) and the reference information (RFI) and/or
- control, in the failure-mode operation, the pump capacity (PPC) based at least on the individual pressure increase (IPI), on the pump capacity (PCC) of the pump (42), and a failure-mode specific adaptation of a deadband (DB) for controlling the pump capacity (PCC).

2. The controller (80) according to claim 1, wherein the controller (80) includes a proportional integral controller module for controlling the pump capacity (PCC).

3. The controller (80) according to any one of the preceding claims, wherein the controller (80) is configured to determine that the external signals (EXS) are received no longer if at least a part of the external signals (EXS) has been not received for at least a predetermined period of time.

4. The controller (80) according to any one of the preceding claims, wherein the deadband (DB) has an upper deadband limit (UDBL) and wherein the controller (80) is configured to decrease the upper deadband limit (UDBL), in the failure-mode operation, when a transitional average of the pump capacity (PPC) is close to or at a maximum pump capacity (PPCmax) and/or
wherein the deadband (DB) has a lower deadband limit (LDBL) and wherein the controller (80) is configured to increase the lower deadband limit (LDBL), in the failure-mode operation, when the transitional average of the pump capacity (PPC) is close to or at a minimum pump capacity (PPCmin).

5. The controller (80) according to any one of the preceding claims, wherein the external signals (EXS) include at least information on the global pressure drop (GPD) in the first fluid circuit (10),
wherein the controller (80) is configured to, in the normal-mode operation, store the reference information (RFI) in the memory (83), wherein the refence information (RFI) is based at least on the global pressure drop (GPD).

6. The controller (80) according to claim 5, wherein the controller (80) is configured to, in the normal-mode operation, determine a transitional average difference (TAD), which is a transitional average of a difference (PDI) between the individual pressure increase (IPI) and the global pressure drop (GPD), and to store the transitional average difference (TAD) in the memory (83) such that reference information (RFI) includes the transitional average difference (TAD).

7. The controller (80) according to claim 6, wherein the controller (80) is configured to determine, in the normal-mode operation, the transitional average difference (TAD) for at least a certain time period (tTAD), a minimum number of values of the global pressure drop (GDP), and/or a minimum number of values of the individual pressure increase (IPI).

8. The controller (80) according to any one of the preceding claims, wherein controller (80) is configured to, in the failure-mode operation,
- offset the individual pressure increase (IPI) based on the reference information (RFI) and
- use the offset individual pressure increase (OIPI) for controlling the pump (31).

9. The controller (80) according to any one of the preceding claims, wherein the controller (80) is configured to, in the normal-mode operation,
- receive the global average pump capacity (GAPC), e.g. from a data processing means (14, 80a, 80b) and/or receive the individual pump capacities (PCCa, PCCb) of the other pumps (42a, 42b) and to determine the global average pump capacity (GAPC) based on the received pump capacities (PCCa, PCCb) of the other pumps (42a, 42b) and the pump capacity (PCC) for the pump (42), and
- control the pump (42) based on the global average pump capacity (GAPC).

10. The controller (80) according to claim 9, wherein the controller (80) is configured to, in the normal-mode operation,
- set an upper pump capacity limit (UCL) based on the global average pump capacity (GAPC) and control the pump capacity (PPC) of the pump (31) with the upper pump capacity limit (UCL) as an upper limit for the pump capacity (PCC), and/or
- set a lower pump capacity limit (LCL) based on the global average pump capacity (GAPC) and control the pump capacity (PPC) of the pump (31) with the lower pump capacity limit (LCL) as a lower limit for the pump capacity (PCC).

11. A cooling distribution unit (30), with a pump unit (41) having a pump (42), for a data center cooling system (1),
the data center cooling system (1) comprising a first fluid circuit (10) for providing cooling to parts (16) of an **IT** infrastructure in a data center, and a second fluid circuit (20) for dissipating heat, wherein the first fluid circuit (10) is provided with several pump units (41, 41a, 41b) for cycling a first fluid in the first fluid circuit (10) and provides external signals (EXS) including information on
- a global pressure drop (GDP) in the first fluid circuit (10),
- a global average pump capacity (GAPC) of the pump units (41, 41a, 41b) in the first fluid circuit (10), and/or
- individual pump capacities of other pumps (42a, 42b) of the other pump units (41a, 41b) in the first circuit (10),
wherein the cooling distribution unit (30) comprises:
a first fluid section (40) for fluid coupling with the first fluid circuit (10), wherein the pump unit (41) forms part of the first fluid section (40) and includes measurement means (45, 46) for measuring an individual pressure increase (IPI) of the first fluid in pump unit (41) caused by the pump (41);
a second fluid section (60) for fluid coupling with the second fluid circuit (20);
a heat exchanger (50) for heat coupling between the first fluid section (40) and the second fluid section (60); and
a controller (80) for controlling the pump (41) according to any one of the preceding claims.

12. A data center cooling system (1) including a first fluid circuit (10) for providing cooling to parts (16) of an **IT** infrastructure in the data center, wherein the first fluid circuit (10) is configured to provide external signals (EXS) that are indicative of a global pressure drop (GDP) concerning the first fluid circuit (10), and a second fluid circuit (20) for dissipating heat;
wherein the data center cooling system (1) includes at least two cooling distribution units (30) according to claim 11, wherein the first fluid sections (40) of the at least two cooling distribution units (30) form part of the first fluid circuit (10), and
wherein the first fluid circuit (10) includes a data processing means (14, 80, 80a, 80b) for providing the external signals (EXS).

13. The data center cooling center according to claim 12, wherein one of the controllers (80, 80a, 80b) is the data processing means or wherein the first fluid circuit (10) includes a master controller (14) as the data processing means.

14. Method for controlling a pump (42) with a variable pump capacity (PCC) of a pump unit (41), for example in a cooling distribution unit (30) according to claim 11, in a first fluid circuit (10),
wherein the first fluid circuit (10) is provided with several pump units (41, 41a, 41b) that are cycling a first fluid in the first fluid circuit (10) and wherein a data processing means (14, 80, 80a, 80b) provides external signals (EXS) including information on
- a global pressure drop (GDP) in the first fluid circuit (10),
- a global average pump capacity (GAPC) of the pump units (41, 41a, 41b) in the first fluid circuit (10), and/or
- individual pump capacities of the other pumps (42a, 42b) of the other pump units (41a, 41b) in the first circuit (10),
wherein measurement means (45, 46) of the pump unit (41) provide internal signals (ITS) that are indicative of an individual pressure increase (IPI) of the first fluid in the pump unit (41) caused by the pump (42);
wherein the method comprises:
- obtaining, with the controller (80), the individual pressure increase (IPI) based on the internal signals (ITS),
- receiving, in a normal-mode operation, the external signals (EXS) by the controller (80),
- controlling, in the normal-mode operation, the pump capacity (PCC) with the controller (80) based on the external signals (EXS);
- determining, with the controller (80), that controller (80) receives the external signals (EXS) are received no longer and/or receiving, with the controller (80), a failure-indication signal from the first fluid circuit (10), and, in response, automatic switching of the controller (80) to a failure-mode operation;
wherein the method further comprises
- obtaining, with the controller (80), the individual pressure increase (IPI) based on the internal signals (ITS), storing reference information (RFI) in the memory (83), wherein the refence information (RFI) is based at least on a part of the external signals (EXS) received by the controller (80) in the normal-mode operation, and controlling, in the failure-mode operation, the pump capacity (PCC) with the controller (80) based at least on the individual pressure increase (IPI) and the reference information (RFI)
and/or
- controlling, in the failure-mode operation, the pump capacity (PPC) with the controller (80) based at least on the individual pressure increase (IPI), on the pump capacity (PCC) of the pump (42), and a failure-mode specific adaptation of a deadband (DB) for controlling the pump capacity (PCC).
